# EUROPEAN PATENT SPECIFICATION

(11) **EP 2 741 396 B1**
(45) Date of publication and mention of the grant of the patent: **26.05.2021**
(21) Application number: 12196009.0
(22) Date of filing: 07.12.2012
(51) Int. Cl.: H02J 13/00, G01R 21/00, G01D 4/00

(54) **Manufacturing device network**
Herstellungsvorrichtungsnetz
Réseau de fabrication de dispositif

(43) Date of publication of application: 11.06.2014
(73) Proprietor: Airbus Operations GmbH, 21129 Hamburg (DE)
(72) Inventor: Neuhaus, Frank, 21635 Jork (DE); Juedes, Wolfgang, 21640 Nottensdorf (DE); Scholl, Gerd, 22393 Hamburg (DE); Heynicke, Ralf, 23909 Ratzeburg (DE)

(56) References cited:
- EP-A2- 2 385 352
- EP-A2- 2 442 429

## Description

The present invention relates to a manufacturing device network comprising a power supply line having a plurality of supply connectors, at least one manufacturing device provided with a device supply line, the device supply line having a device connector at the end of the device supply line remote from the manufacturing device for connecting the manufacturing device with one of said supply connectors, said supply connectors and said device connector being adapted to be detachably coupled with each other.

The power supply line and the device supply line may preferably comprise an electric cable, a hydraulic tube, or a pneumatic tube. Preferably, each supply connector of the power supply line is connected to a separate manufacturing device through a separate device supply line, each device supply line having an associated device connector detachably coupled to a respective supply connector. By connecting the device connector to the supply connector the manufacturing device may be connected to the power supply line supplying power to said manufacturing device. However, if the manufacturing device is intended to be displaced, the device connector may be disconnected from the supply connector.

Various manufacturing device networks are known in the art including one or more manufacturing devices each connected to a power supply line by a device supply line transmitting power from the power supply line to the associated manufacturing device. For example in an assembly line a plurality of electrically or compressed air driven tools are selectively connected to a corresponding supply line.

For issues of quality control it is desired to monitor exactly when which amount of power has been supplied to which manufacturing device by which device supply line.

Therefore, it is commonly known in the art to provide any manufacturing device with a monitoring unit comprising sensor means for monitoring the power required by the manufacturing device, and identification means for identifying the particular manufacturing device in the associated power supply network. However, such monitoring units, i.e. such sensor means and such identification means, integrated into the manufacturing device usually have a specific design of the producer of the manufacturing device, whereas monitoring units of different producers are usually not compatible with one another, so that for different manufacturing devices different power supply network interfaces, i.e. different device supply lines, become necessary and not every manufacturing device may be used with any device supply line. Thereby, efficiency of the manufacturing device network is reduced and unpleasant costs are generated.

Moreover, not even all manufacturing devices commonly used are provided with such monitoring units. However, in particular for quality control reasons, it is considerably advantageous for a manufacturer having multiple manufacturing devices to be able to monitor which manufacturing device is connected to which of the device supply lines and at which specific connector thereof and how much power has been transmitted to the manufacturing device at which time

EP 2 385 352 A2 discloses a power monitoring apparatus for household appliances.

Thus, the object of the present invention is to provide a manufacturing device network, wherein the consumption of power by the manufacturing device is monitored and each manufacturing device may be identified in the associated power supply network, independent from the producer or the design of the manufacturing device.

This object is achieved by independent claims 1, 11 and 12. The supply connectors and/or said device connector are provided with a monitoring unit comprising sensor means and communication means, a receiving unit is provided for receiving data from the communication means, the device connector is provided with an identifying unit being adapted to transmit an identification signal to the receiving unit, said identification signal identifying the manufacturing device, said sensor means being adapted to monitor a parameter being related to the transfer of power through said device connector to the manufacturing device and to transmit a signal representing said parameter to the communication means, and said communication means being adapted to transmit a signal representing said parameter to the receiving unit.

Thus, the monitoring unit including sensor means and communication means is provided not on the manufacturing device itself but on the device supply line or on the power supply line, more detailed on the device connector or on the supply connector. Further, the identifying unit is arranged on the device connector so as to allow identifying which devices are connected to the power supply line.

In such a manner the monitoring unit and the identifying unit are decoupled from the respective manufacturing device and their design is not necessarily determined by the producer of the manufacturing device itself, as the monitoring unit and the identifying unit may be produced and provided, i.e. arranged on the supply connector or on the device connector, independent from the manufacturing device to which power is transmitted through said device and supply connectors.

The monitoring unit may be formed either integrally with the supply connector or the device connector, or it may be detachably connected to said supply connector or device connector. Further, the device connector may be detachably coupled to the device supply line and/or the device supply line may be detachably coupled to the manufacturing device.

There may be either one common receiving unit receiving data from all monitoring units, or multiple receiving units each receiving data from a separate associated monitoring unit. However, regardless of the number of receiving units in a network according to the present invention it is possible to store the data received by the receiving unit(s) in single memory means.

The monitoring unit and the identifying unit may be arranged in such a manner that either the monitoring unit and the identifying unit are arranged together on the device connector or the monitoring unit is arranged on the supply connector and the identifying unit is arranged on the device connector. In addition, it is also possible that monitoring units may be arranged on both the device connector and the supply connector, such that sensor means are arranged on both connectors.

The network according to the present invention allows to monitor the use and to record use related data, inter alia by detecting the power consumption via the sensor means, and transmitting the respective parameters to the receiving unit so that these parameters may be stored in corresponding memory means. Moreover, the identifying unit on the device connector enables the receiving unit to identify those manufacturing devices which are currently connected to the network and the power consumption of which is monitored. Based on these data it is possible that the relevant parameters of the single steps of a complex manufacturing process may be recorded. In addition, as the units required for this purpose are part of the connectors and not integrated in the manufacturing devices, such devices may easily be integrated in the network.

In a preferred embodiment the monitoring unit is provided on the device connector, the identifying unit is included in the monitoring unit, and the identification signal is transmitted via the network communication means. In such a way a plain power supply line without any monitoring unit or identifying unit may be provided, wherein the device supply line may be separately produced with or equipped with a monitoring unit comprising an identifying unit integrated therein. Such construction is particularly simple and cost effective.

In another preferred embodiment each supply connector is provided with an identification sensor adapted to receive an identification signal transmitted from an identifying unit on a device connector connected to said supply connector, and said identification sensor is adapted to transmit a network identification signal to said receiving unit, said network identification signal identifying the manufacturing device connected to said supply connector. By means of such identification sensor the identification signal transmitted from the identifying unit may be detected and read, whereupon the information of the identification signal together with the identity information of the supply connector to which the manufacturing device is connected is transmitted to the receiving unit in form of a network identification signal. In such a way the receiving section obtains concentrated information about which manufacturing device is connected at which time to which supply connector of the power supply line.

In yet another preferred embodiment each supply connector is provided with a network monitoring unit comprising network sensor means and network communication means, said network sensor means being adapted to monitor a parameter being related to the transfer of power through said device connector to the manufacturing device and to transmit a signal representing said parameter to the network communication means, said network communication means being adapted to transmit a signal representing said parameter to the receiving unit. The network monitoring unit may be provided in addition to or instead of a monitoring unit provided on the device connector.

In a further preferred embodiment a monitoring unit is provided on the device connectors and an additional network monitoring unit as described before is employed, wherein the network monitoring unit is provided with a network identifying unit being adapted to transmit a network identification signal, preferably via the network communication means, to the receiving unit said network identification signal identifying the supply connector.

If the monitoring unit and the network monitoring unit are adapted such that both the identifying unit and the network identifying unit transmit a identification signal to the receiving unit immediately upon detection of a transfer of power through the device and supply connectors by the respective sensor means, these signal will be received simultaneously so that the receiving unit will recognize that the supply connector and the device connector identified by the respective signals are coupled with each other and this information can be stored.

Further, if more than two identification signals are received at the same time by the receiving unit which would not allow to unambiguously identify which connectors are coupled with each other, the actuator means which are described below and allow to interrupt and open the transfer of power through a pair of supply and device connectors, are activated on those supply connectors which have simultaneously transmitted a signal to stop the transfer of power. Subsequently, these actuators are deactivated one after the other with a time interval in between. As the identifying units will again immediately transmit signals when power starts to be transferred, this results in subsequent pairs of identification signals which will allow to identify which supply connectors are coupled with which device connectors.

Thus, in this preferred embodiment it is possible to detect which connectors are coupled without the need to provide receiving means on the supply connectors or the device connectors.

As an alternative, it is preferred that the afore-mentioned identification sensor is included in the network monitoring unit and that said network identification signal is transmitted via said network communication means. In such a way a compact and cost effective construction of the network monitoring unit and of the entire manufacturing device network is provided.

Actuator means adapted to stop operation of the manufacturing device are provided according to the present invention. In particular, according to the invention, said actuator means are provided on said monitoring unit and are adapted to stop power from being supplied to the manufacturing device through said device supply line. Further, control means are provided in signal connection to said sensor means and said actuator means, said control means being adapted to output a control signal to the actuator means in dependence of a sensor signal provided by the sensor means. However, the actuator means may also be provided on the network monitoring unit, wherein the control means being adapted to output a control signal to the actuator means in dependence of a network sensor signal provided by the network sensor means.

It is also according to the present invention that said control means are provided on said receiving unit, and said sensor signal is represented by said parameter related to the transfer of power through said device connector to the manufacturing device. In such a case the sensor signal may be transmitted to the receiving unit, i.e. to the control means, by the communication means in the form of a communication signal also representing said parameter related to the transfer of power through said device connector to the manufacturing device, and the control signal may be transmitted from the control means to the actuator means via the communication means.

The control means according to the invention control the actuator means in such a manner that when the parameter related to the transfer of power through the device connector to the manufacturing device monitored by the sensor means overruns or underruns a predetermined threshold value of said parameter, the actuator means are activated in order to stop operation of the manufacturing device by stopping the transfer of power from the supply connector to the manufacturing device. In such a manner overload conditions or emergency conditions of the manufacturing device may be anticipated and prevented.

According to a preferred embodiment said receiving unit is arranged remote from said monitoring unit. In such a case a single common receiving unit including control means adapted to control the actuator means in all monitoring units may preferably be employed. In particular, it is preferred that said receiving unit is connected to said monitoring unit via a wireless data connection. Such wireless data connection appears most convenient and allows high flexibility of the position of the receiving unit and the monitoring unit or units. Further, by employing only one common receiving unit space and costs necessary for employing multiple receiving units may be saved.

Alternatively, it is preferred that said receiving unit is connected to said monitoring unit via a data cable. The connection via data cable might be the most reliable alternative.

According to the invention, memory means are provided on said receiving unit. Such memory means may store the recorded data of the monitoring unit or network monitoring unit, i.e. e.g. the history of the parameter related to the transfer of power through the device connector to the manufacturing device, the history of the identification signals received by the identification sensor, or the history of the initiation of the actuator means.

Said device supply line according to the invention is detachably connected to said manufacturing device. In such a way the device supply line and the device connector together with a monitoring unit do not form part of the manufacturing device, i.e. they may be produced, provided, and replaced individually and separate from the manufacturing device, so that the compatibility of such monitoring units and device supply lines is not depending on the specific producer of the manufacturing device.

In the following a preferred embodiment of the manufacturing device network according to the present invention is described by means of a drawing. Said drawing shows in
- Fig. 1: a schematic illustration of a manufacturing device network comprising three manufacturing devices connected to the power supply line, and a receiving unit,
- Fig. 2: a schematic detailed view of a first embodiment of a monitoring unit, a network monitoring unit and the receiving unit of the manufacturing device network shown in Fig. 1 and
- Fig. 3: a schematic detailed view of a second embodiment of a monitoring unit, a network monitoring unit and the receiving unit of the manufacturing device network shown in Fig. 1.

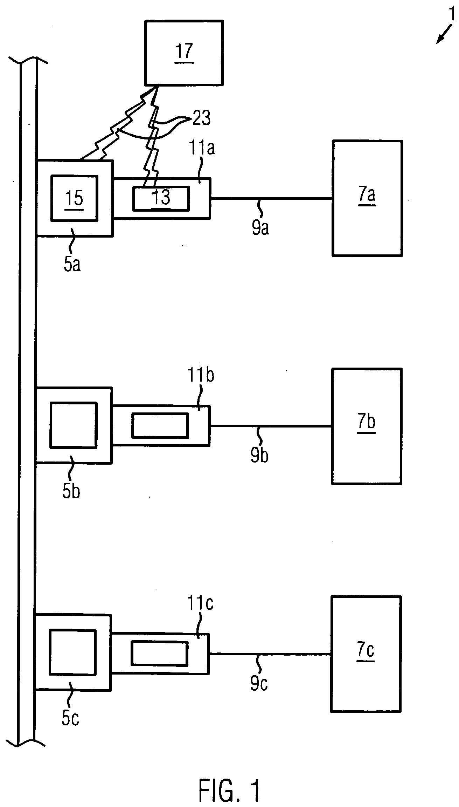

In Figure 1 a manufacturing device network 1 is illustrated comprising a power supply line 3 having three supply connectors 5a, 5b, 5c each of which being connected to a respective manufacturing device 7a, 7b, 7c by means of a respective device supply line 9a, 9b, 9c. Each device supply line 9a, 9b, 9c is provided at its end remote from the manufacturing device with a device connector 11a, 11b, 11c which is detachably coupled to a respective one of said supply connectors 5a, 5b, 5c.

The power supplied to the manufacturing device 7a, 7b, 7c through said power supply line 3 and said device supply lines 9a, 9b, 9c may be various kinds of power, such as hydraulic power or pneumatic power, i.e. compressed air, but in the current embodiment is electric power, wherein the power supply line 3 and the device supply 9a, 9b, 9c lines are formed as electric cables.

The number of three manufacturing devices 7a, 7b, 7c and three supply connectors 5a, 5b, 5c, respectively, is intended to be understood as an example only, wherein a higher or lower number is also possible. As in the present embodiment the connection of said three manufacturing devices 7a, 7b, 7c to the respective three supply connectors 5a, 5b, 5c of the power supply line 3 is formed identically, the following description of the first embodiment refers to only one device 7a of said manufacturing devices 7a, 7b, 7c connected to one connector 5a of said supply connectors 5a, 5b, 5c.

The device connector 11a according to the first embodiment is detachably connected to the device supply line 9a, and the device supply line 9a is detachably connected to the manufacturing device 7a. Further, the device connector 11a comprises a monitoring unit 13 and the supply connector 5a comprises a network monitoring unit 15.

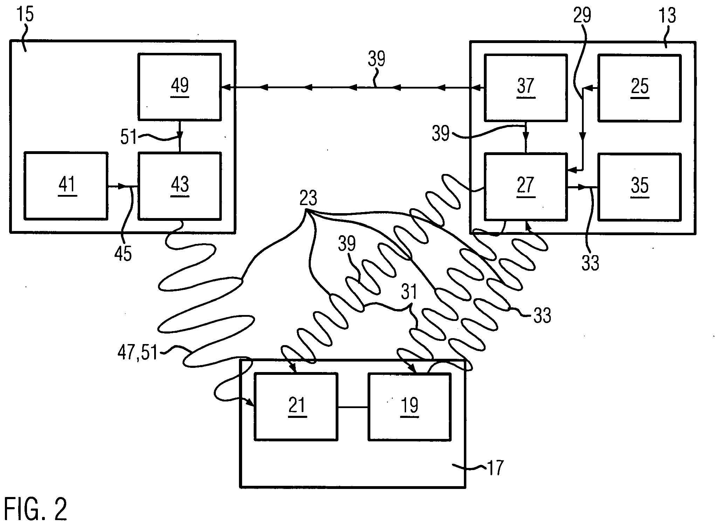

Additionally, a receiving unit 17 is provided in the manufacturing device network 1 including control means 19 and memory means 21, said receiving unit 17 being arranged remote from the monitoring unit 13 and being connected to said monitoring unit 13 via a wireless data connection 23 (see Figure 2). However, it is conceivable that the receiving unit 17 may be connected to the monitoring unit 13 via a data cable.

As shown in Figure 2 the monitoring unit 13 comprises sensor means 25 and communication means 27, wherein said sensor means 25 are adapted to monitor a parameter related to the transfer of power through the device connector 11a to the manufacturing device 7a and to transmit a sensor signal 29 representing said parameter to the communication means 27.

Said communication means 27 in turn are adapted to transmit a communication signal 31 representing said parameter to the receiving unit 17, i.e. to the memory means 21 and to the control means 19 provided on said receiving unit 17. Said memory means 21 are adapted to store the history of said parameter monitored by the sensor means 25. Said control means 19 are adapted to output a control signal 33 in dependence of said communication signal 31 and said sensor signal 29 included in said communication signal 31, respectively, i.e. in dependence of said parameter related to the transfer of power through the device connector 11a to the manufacturing device 7a.

The monitoring unit 13 further comprises actuator means 35 adapted to stop operation of the manufacturing device 7a in response to a control signal 33 received from the control means 19, by stopping the power from being transferred to the manufacturing device 7a through the device supply line 9a.

Moreover, the monitoring unit 13 comprises an identifying unit 37 adapted to transmit an identification signal 39 to the receiving unit 17, in particular to the memory means 21 provided on said receiving unit 17, by the communication means 27, and adapted to transmit an identification signal 39 to the supply connector 5a. Said identification signals 39 identifying the manufacturing device 7a connected to the device connector 11a provided with the monitoring unit 13 including the identifying unit 37 transmitting said identification signals 39.

As also shown in Figure 2, the network monitoring unit 15 provided on the supply connector 5a is in signal connection to the monitoring unit 13, when the supply connector 5a is connected to the device connector 11a. The network monitoring unit 15 comprises network sensor means 41 and network communication means 43, wherein said network sensor means 41 are adapted to monitor a parameter related to the transfer of power through said device connector 11a to the manufacturing device 7a, and to transmit a network sensor signal 45 representing said parameter to the network communication means 43, and wherein said network communication means 43 being adapted to transmit a network communication signal 47 representing said parameter to the receiving unit 17, preferably to the memory means 21.

The network monitoring unit 15 further comprises an identification sensor 49 adapted to receive an identification signal 39 transmitted from the identifying unit 37 of the monitoring unit 13 on the device connector 11a when connected to the supply connector 5a. In response to the identification signal 39 received from the identifying unit 37 said identification sensor 49 is adapted to transmit a network identification signal 51 to the receiving unit 17, in particular to the memory means 21 provided on said receiving unit 17, wherein said network identification signal 51 identifies the manufacturing device 7a connected to the supply connector 5a. According to the present embodiment the network identification signal 51 is transmitted to the receiving unit 17 via the network communication means 43.

The memory means 21 are preferably adapted to store the history of all signals received or transmitted by the receiving unit 17, in particular the history of the communication signal 31 and the network communication signal 47, or the parameter related to the transfer of power through said device connector 11a to the manufacturing device 7a, the control signal 33, the identification signal 39, and the network identification signal 51. In the present embodiment the communication signal 31, the network communication signal 47, the control signal 33, the identification signal 39, and the network identification signal 51 are transmitted to or from the receiving unit 17 via a wireless data connection 23. In the present embodiment the identifying unit 37 further being adapted to transmit an identification signal 39 to both the receiving unit 17 and the identification sensor 49, and the receiving unit 17 is adapted to receive both the identification signal 39 from the identifying unit 37 and the network identification signal 51 from the identification sensor 49. However, it may also be advantageous, when either the identification signal 39 is transmitted to the receiving unit 17, or the network identification signal 51 is transmitted from the identification sensor 49 to the receiving unit 17 in response to the identification signal 39 received from the identifying unit 37.

The first embodiment of the manufacturing device network 1 according to the present invention as described before is operated as follows.

Firstly, the manufacturing device 7a is connected to the power supply line 3 by connecting the device connector 11a of the device supply line 9a provided on said manufacturing device 7a to one of the supply connectors 5a provided on said power supply line 3. Subsequently, the manufacturing device 7a is operated, while power is supplied to said manufacturing device 7a from the power supply line 3 via the device supply line 9a.

Meanwhile, a parameter related to this transfer of power through the device connector 11a to the manufacturing device 7a is monitored by the sensor means 25 provided on the monitoring unit 13 on the device connector 11a and by the network sensor means 41 provided on the network monitoring unit 15 on the supply connector 5a. The sensor means 25 transmit a sensor signal 29 representing said parameter to the communication means 27 and the communication means 27 transmit a communication signal 31 representing said parameter to the receiving unit 17, in particular to the memory means 21 and to the control means 19, by a wireless data connection 23. The network sensor means 41 transmit a network sensor signal 45 representing said parameter to the network communication means 43 and the network communication means 43 transmit a network communication signal 47 representing said parameter to the receiving unit 17 as well, in particular to the memory means 21, by a wireless data connection 23.

In the memory means 21 the history of said parameter is stored in order to be analysed for quality control issues. By the control means 19 in response to the received communication signal 31 a control signal 33 is transmitted to the communication means 27 by a wireless data connection 23, and from there transmitted to the actuator means 35 which in turn stop the power supplied to the manufacturing device 7a through the device supply line 9a in order to stop operation of said manufacturing device 7a, when said parameter monitored by said sensor means overruns or underruns a predetermined threshold value of said parameter corresponding to a critical operating condition of the manufacturing device 7a. In such a manner the manufacturing device 7a is for example prevented from defective operation or from being damaged.

The identifying unit 37 provided on the monitoring unit 13 on the device connector 11a transmits an identification signal 39 identifying the manufacturing device 7a via the communication means 27 and a wireless data connection 23 to the receiving unit 17 in order to be stored in the memory means 21, and to the identification sensor 49 on the network monitoring unit 15 on the supply connector 5a, said identification sensor 49 in turn transmitting a network identification signal 51 identifying the manufacturing device 7a connected to this particular supply connector 5a, via the network communication means 43 and a wireless data connection 23 to the receiving unit 17 in order to be stored in the memory means 21 and may be analysed for quality control issues. Thus, it is also possible to store in the memory means which manufacturing device 7a, 7b, 7c is connected to which particular supply connector 5a, 5b, 5c.

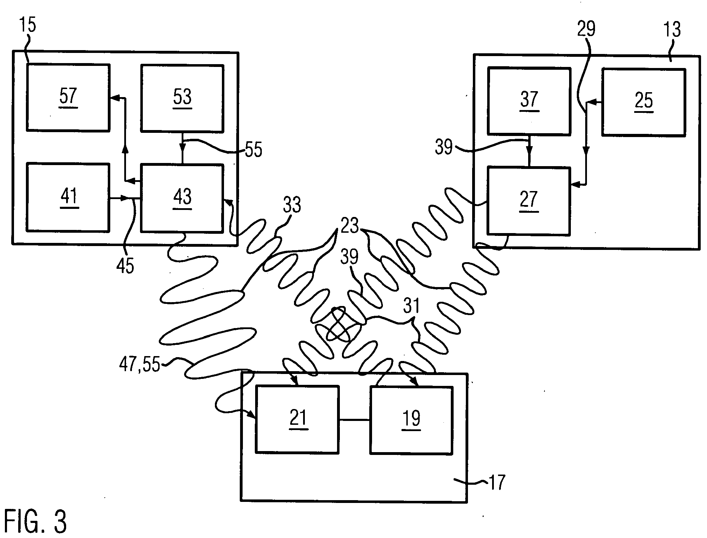

In Figure 3 a second embodiment of a combination of a monitoring unit 13 arranged on a device connector 11a and a network monitoring unit 15 positioned on a supply connector 5a together with a receiving unit 17 is shown. The receiving unit 17 includes control means 19 and memory means 21 and is arranged remote from the monitoring unit 13 and the network monitoring unit 15 and being connected to the monitoring unit 13 and the network monitoring unit 15 via a wireless data connection 23. However, as in the first embodiment it is conceivable that the receiving unit 17 may be connected to the monitoring unit 13 via a data cable.

As shown in Figure 3 the monitoring unit 13 comprises sensor means 25 and communication means 27, wherein said sensor means 25 are adapted to monitor a parameter related to the transfer of power through the device connector 11a to the manufacturing device 7a and to transmit a sensor signal 29 representing said parameter to the communication means 27.

Said communication means 27 in turn are adapted to transmit a communication signal 31 representing said parameter to the receiving unit 17. Said control means 19 are adapted to output a control signal 33 in dependence of said communication signal 31 and said sensor signal 29 included in said communication signal 31, respectively, i.e. in dependence of said parameter related to the transfer of power through the device connector 11a to the manufacturing device 7a.

Moreover, the monitoring unit 13 comprises an identifying unit 37 adapted to transmit an identification signal 39 to the receiving unit 17, in particular to the memory means 21 provided on said receiving unit 17, by the communication means 27. Said identification signal 39 identifies the manufacturing device 7a connected to the device connector 11a provided with the monitoring unit 13 including the identifying unit 37 transmitting said identification signals 39.

As also shown in Figure 3, the network monitoring unit 15 provided on the supply connector 5a comprises network sensor means 41 and network communication means 43, wherein said network sensor means 41 are adapted to monitor a parameter related to the transfer of power through said device connector 11a to the manufacturing device 7a, and to transmit a network sensor signal 45 representing said parameter to the network communication means 43. The network communication means 43 are adapted to transmit a network communication signal 47 representing said parameter to the receiving unit 17, preferably to the memory means 21.

The network monitoring unit 15 further comprises a network identifying unit 53 adapted to transmit a network identification signal 55 to the receiving unit 17, in particular to the memory means 21 provided on said receiving unit 17, wherein said network identification signal 55 identifies the supply connector 5a. According to the second embodiment the network identification signal 55 is transmitted to the receiving unit 17 via the network communication means 43.

The network monitoring unit 15 further comprises network actuator means 57 adapted to stop operation of the manufacturing device 7a in response to a control signal 33 received from the control means 19, by stopping the power from being transferred to the manufacturing device 7a through the device supply line 9a.

The memory means 21 are preferably adapted to store the history of all signals received or transmitted by the receiving unit 17, in particular the history of the communication signal 31 and the network communication signal 47, or the parameter related to the transfer of power through said device connector 11a to the manufacturing device 7a, the control signal 33, the identification signal 39, and the network identification signal 55. In the second embodiment the communication signal 31, the network communication signal 47, the control signal 33, the identification signal 39, and the network identification signal 55 are transmitted to or from the receiving unit 17 via a wireless data connection 23 as well.

The second embodiment of the manufacturing device network 1 according to the present invention as described before is operated as follows.

Firstly, the manufacturing device 7a is connected to the power supply line 3 by connecting the device connector 11a of the device supply line 9a provided on said manufacturing device 7a to one of the supply connectors 5a provided on said power supply line 3. Subsequently, the manufacturing device 7a is operated, while power is supplied to said manufacturing device 7a from the power supply line 3 via the device supply line 9a.

A parameter related to this transfer of power through the device connector 11a to the manufacturing device 7a is monitored by the sensor means 25 provided on the monitoring unit 13 and by the network sensor means 41 provided on the network monitoring unit 15. The sensor means 25 transmit a sensor signal 29 representing said parameter to the communication means 27 and the communication means 27 transmit a communication signal 31 representing said parameter to the receiving unit 17. The network sensor means 41 transmit a network sensor signal 45 representing said parameter to the network communication means 43 and the network communication means 43 transmit a network communication signal 47 representing said parameter to the receiving unit 17 as well.

In the memory means 21 the history of said parameter is stored in order to be analysed for quality control issues. By the control means 19 in response to the received communication signal 31 a control signal 33 is transmitted to the network communication means 43, and from there transmitted to the network actuator means 57 which in turn stop the power supplied to the manufacturing device 7a through the device supply line 9a in order to stop operation of said manufacturing device 7a, when said parameter monitored by said sensor means overruns or underruns a predetermined threshold value of said parameter.

The identifying unit 37 provided on the monitoring unit 13 on the device connector 11a transmits an identification signal 39 identifying the manufacturing device 7a via the communication means 27 upon detection of transfer of power by the sensor means 25. At the same time the network identifying unit 53 will send a network identification signal 55 identifying the supply connector 5a to the receiving unit 17. As these two signals 39, 55 will be received at the same time at the receiving unit, it can be concluded that the respective supply connector 5a and the device connector 11a are coupled and a corresponding entry is made in the memory means 21.

However, if more than two identification signals 39, 55 are received at the same time by the receiving unit 17 which would not allow to unambiguously identify which connectors 5a, 11a are connected to each other, the network actuator means 57 are activated on those supply connectors 5a which have simultaneously transmitted a network identification signal 55 to stop the transfer of power. Subsequently, these actuators 57 are deactivated one after the other with a time interval in between. As the network identifying units 53 will again immediately transmit signals 55 when power starts to be transferred, this results in subsequent pairs of identification signals 39, 55 which will allow to identify which supply connectors 5a are coupled with which device connectors 11a.

Thus, in this second embodiment it is possible to detect which connectors 5a, 11a are coupled without the need to provide any receiving means on the supply connectors or the device connectors.

In conclusion with the afore-mentioned construction of the manufacturing device network 1 the monitoring unit 13 and the network monitoring unit 15 are provided independent and decoupled from the manufacturing device 7a, on the device connector 11a and on the supply connector 5a, respectively, which might be disconnected from the manufacturing device 7a and thus may be produced and provided individually from the manufacturing device 7a. This allows to easily adapt different types of devices, possibly from different suppliers for being integrated in the network, as it is not necessary to make modifications on the device itself but only to mount at the identifying unit (37) on the device connector (11a, 11b, 11c).

## Claims

1. A quality control manufacturing device network (1) for monitoring for quality control reasons which manufacturing device is connected to which device supply line and how much power has been transmitted to the manufacturing device at which time, the network comprising:
a power supply line (3) having a plurality of supply connectors (5a, 5b, 5c),
a plurality of manufacturing devices (7a, 7b, 7c), each provided with a device supply line (9a, 9b, 9c), each device supply line (9a, 9b, 9c) having a device connector (11a, 11b, 11c) at the end of the device supply line (9a, 9b, 9c) remote from the manufacturing device (7a, 7b, 7c) for connecting the manufacturing device (7a, 7b, 7c) with one of said supply connectors (5a, 5b, 5c),
said supply connectors (5a, 5b, 5c) and said device connectors (11a, 11b, 11c) being adapted to be detachably coupled with each other,
**characterized in that**
the supply connectors (5a, 5b, 5c) and/or said device connectors (11a, 11b, 11c) are each provided with a monitoring unit (13) comprising sensor means (25) and communication means (27),
a receiving unit (17) is provided for receiving data from the communication means (27),
the device connectors (11a, 11b, 11c) are each provided with an identifying unit (37) being adapted to transmit an identification signal (39) to the receiving unit (17), said identification signal (39) identifying the manufacturing devices (7a, 7b, 7c),
each sensor means (25) being adapted to monitor a parameter being related to the transfer of power through the corresponding device connector (11a, 11b, 11c) to the corresponding manufacturing device (7a, 7b, 7c) and to transmit a signal (29) representing said parameter to the communication means (27), and
said communication means (27) being adapted to transmit a signal (31) representing said parameter to the receiving unit (17),
wherein memory means (21) are provided on said receiving unit (17), said memory means (21) storing the his- tory of the parameter related to the transfer of power through each device connector to the corresponding manufacturing device in order to be analysed for quality control issues,
wherein actuator means (35) adapted to stop operation of the manufacturing devices (7a, 7b, 7c) are provided,
wherein said actuator means (35) are provided on said monitoring unit (13) and are adapted to stop power from being supplied to the manufacturing devices (7a, 7b, 7c) through said device supply lines (9a, 9b, 9c),
wherein control means (19) are provided in signal connection to said sensor means (25) and said actuator means (35), said control means (19) being adapted to out- put a control signal (33) to the actuator means (35) in dependence of a sensor signal (29) provided by the sensor means (25),
wherein said control means (19) are provided on said receiving unit (17), and said sensor signal (29) is represented by said parameter related to the transfer of power through said device connectors (11a, 11b, 11c) to the manufacturing devices (7a, 7b, 7c), and
wherein the control means (19) are adapted to control the actuator means (35) so as to anticipate or prevent overload conditions or emergency conditions of the manufacturing devices (7a, 7b, 7c), wherein, when the parameter related to the transfer of power through one of the device connectors (11a, 11b, 11c) to the corresponding manufacturing device (7a, 7b, 7c) monitored by the sensor means (25) overruns or underruns a predetermined threshold value of said parameter corresponding to a critical operating condition of the manufacturing device (7a, 7b, 7c), the actuator means (35) are activated in order to stop operation of the manufacturing device (7a, 7b, 7c) by stop- ping the transfer of power from the corresponding supply connector (5a, 5b, 5c) to the manufacturing device (7a, 7b, 7c).

2. A network according to claim 1, wherein the monitoring unit (13) is provided on the device connectors (11a, 11b, 11c),
wherein the identifying unit (37) is included in the monitoring unit (13), and
wherein the identification signal (39) is transmitted via the communication means (27).

3. A network according to claims 1 or 2, wherein each supply connector (5a, 5b, 5c) is provided with an identification sensor (49) adapted to receive an identification signal (39) transmitted from a device connectors (11a, 11b, 11c) connected to said supply connector (5a, 5b, 5c) and
wherein said identification sensor (49) is adapted to transmit a network identification signal (51) to said receiving unit (17), said network identification signal (51) identifying the manufacturing devices (7a, 7b, 7c) connected to said supply connector (5a, 5b, 5c).

4. A network according to any of claims 1 to 3, wherein each supply connector (5a, 5b, 5c) is provided with a network monitoring unit (15) comprising network sensor means (41) and network communication means (43),
said network sensor means (41) being adapted to monitor a parameter being related to the transfer of power through said device connectors (11a, 11b, 11c) to the manufacturing devices (7a, 7b, 7c) and to transmit a signal (45) representing said parameter to the network communication means (43),
said network communication means (43) being adapted to transmit a signal (47) representing said parameter to the receiving unit (17).

5. A network according to claim 4, wherein the network monitoring unit (15) is provided with a network identifying unit (53) being adapted to transmit a network identification signal (55), preferably via the network communication means (43), to the receiving unit (17) said network identification signal (55) identifying the supply connector (5a).

6. A network according to claims 3 and 4, wherein said identification sensor (49) is included in the network monitoring unit (15) and
wherein said network identification signal (51) is transmitted via said network communication means (43).

7. A network according to claim 1, wherein said receiving unit (17) is arranged remote from said monitoring unit (13).

8. A network according to claim 7, wherein said receiving unit (17) is connected to said monitoring unit (13) via a wireless data connection (23).

9. A network according to claim 7, wherein said receiving unit (17) is connected to said monitoring unit (13) via a data cable.

10. A network according to one of claims 1 to 9, wherein said device supply lines (9a, 9b, 9c) are detachably connected to said manufacturing devices (7a, 7b, 7c).

11. A use of a manufacturing device network (1) for quality control analysis, the network comprising:
a power supply line (3) having a plurality of supply connectors (5a, 5b, 5c),
a plurality of manufacturing devices (7a, 7b, 7c), each provided with a device supply line (9a, 9b, 9c), each device supply line (9a, 9b, 9c) having a device connector (11a, 11b, 11c) at the end of the device supply line (9a, 9b, 9c) remote from the manufacturing device (7a, 7b, 7c) for connecting the manufacturing device (7a, 7b, 7c) with one of said supply connectors (5a, 5b, 5c),
said supply connectors (5a, 5b, 5c) and said device connectors (11a, 11b, 11c) being adapted to be detachably coupled with each other,
wherein the supply connectors (5a, 5b, 5c) and/or said device connectors (11a, 11b, 11c) are each provided with a monitoring unit (13) comprising sensor means (25) and communication means (27),
wherein a receiving unit (17) is provided for receiving data from the communication means (27),
wherein the device connectors (11a, 11b, 11c) are each provided with an identifying unit (37) being adapted to transmit an identification signal (39) to the receiving unit (17), said identification signal (39) identifying the manufacturing devices (7a, 7b, 7c),
wherein each sensor means (25) is adapted to monitor a parameter being related to the transfer of power through the corresponding device connector (11a, 11b, 11c) to the corresponding manufacturing device (7a, 7b, 7c) and to transmit a signal (29) representing said parameter to the communication means (27), and
wherein said communication means (27) is adapted to transmit a signal (31) representing said parameter to the receiving unit (17),
wherein memory means (21) are provided on said receiving unit (17), said memory means (21) storing the history of the parameter related to the transfer of power through each device connector to the corresponding manufacturing device in order to be analysed for quality control issues,
wherein actuator means (35) adapted to stop operation of the manufacturing devices (7a, 7b, 7c) are provided,
wherein said actuator means (35) are provided on said monitoring unit (13) and are adapted to stop power from being supplied to the manufacturing devices (7a, 7b, 7c) through said device supply lines (9a, 9b, 9c),
wherein control means (19) are provided in signal connection to said sensor means (25) and said actuator means (35), said control means (19) being adapted to out- put a control signal (33) to the actuator means (35) in dependence of a sensor signal (29) provided by the sensor means (25),
wherein said control means (19) are provided on said receiving unit (17), and said sensor signal (29) is represented by said parameter related to the transfer of power through said device connectors (11a, 11b, 11c) to the manufacturing devices (7a, 7b, 7c), and
wherein the control means (19) are adapted to control the actuator means (35) so as to anticipate or prevent overload conditions or emergency conditions of the manufacturing devices (7a, 7b, 7c), wherein, when the parameter related to the transfer of power through one of the device connectors (11a, 11b, 11c) to the corresponding manufacturing device (7a, 7b, 7c) monitored by the sensor means (25) overruns or underruns a predetermined threshold value of said parameter corresponding to a critical operating condition of the manufacturing device (7a, 7b, 7c), the actuator means (35) are activated in order to stop operation of the manufacturing device (7a, 7b, 7c) by stop- ping the transfer of power from the corresponding supply connector (5a, 5b, 5c) to the manufacturing device (7a, 7b, 7c).

12. A method for quality control analysis in a manufacturing device network (1), the method comprising:
- Providing a manufacturing device network, (1) comprising
a power supply line (3) having a plurality of supply connectors (5a, 5b, 5c),
a plurality of manufacturing devices (7a, 7b, 7c), each provided with a device supply line (9a, 9b, 9c), each device supply line (9a, 9b, 9c) having a device connector (11a, 11b, 11c) at the end of the device supply line (9a, 9b, 9c) remote from the manufacturing device (7a, 7b, 7c) for connecting the manufacturing device (7a, 7b, 7c) with one of said supply connectors (5a, 5b, 5c),
said supply connectors (5a, 5b, 5c) and said device connectors (11a, 11b, 11c) being adapted to be detachably coupled with each other,
wherein the supply connectors (5a, 5b, 5c) and/or said device connectors (11a, 11b, 11c) are each provided with a monitoring unit (13) comprising sensor means (25) and communication means (27),
wherein a receiving unit (17) is provided for receiving data from the communication means (27),
wherein the device connectors (11a, 11b, 11c) are each provided with an identifying unit (37) being adapted to transmit an identification signal (39) to the receiving unit (17), said identification signal (39) identifying the manufacturing devices (7a, 7b, 7c),
wherein each sensor means (25) is adapted to monitor a parameter being related to the transfer of power through the corresponding device connector (11a, 11b, 11c) to the corresponding manufacturing device (7a, 7b, 7c) and to transmit a signal (29) representing said parameter to the communication means (27),
wherein said communication means (27) are adapted to transmit a signal (31) representing said parameter to the receiving unit (17), and
wherein memory means (21) are provided on said receiving unit (17), said memory means (21) storing the history of the parameter related to the transfer of power through each device connector to the corresponding manufacturing device,
wherein actuator means (35) adapted to stop operation of the manufacturing devices (7a, 7b, 7c) are provided,
wherein said actuator means (35) are provided on said monitoring unit (13) and are adapted to stop power from being supplied to the manufacturing devices (7a, 7b, 7c) through said device supply lines (9a, 9b, 9c),
wherein control means (19) are provided in signal connection to said sensor means (25) and said actuator means (35), said control means (19) being adapted to out- put a control signal (33) to the actuator means (35) in dependence of a sensor signal (29) provided by the sensor means (25),
wherein said control means (19) are provided on said receiving unit (17), and said sensor signal (29) is represented by said parameter related to the transfer of power through said device connectors (11a, 11b, 11c) to the manufacturing devices (7a, 7b, 7c), and
wherein the control means (19) are adapted to control the actuator means (35) so as to anticipate or prevent overload conditions or emergency conditions of the manufacturing devices (7a, 7b, 7c), wherein, when the parameter related to the transfer of power through one of the device connectors (11a, 11b, 11c) to the corresponding manufacturing device (7a, 7b, 7c) monitored by the sensor means (25) overruns or underruns a predetermined threshold value of said parameter corresponding to a critical operating condition of the manufacturing device (7a, 7b, 7c), the actuator means (35) are activated in order to stop operation of the manufacturing device (7a, 7b, 7c) by stop- ping the transfer of power from the corresponding supply connector (5a, 5b, 5c) to the manufacturing device (7a, 7b, 7c), and
- Analysing the stored history of the parameter related to the transfer of power for quality control issues.

## Patentansprüche

1. Qualitätskontroll-Fertigungsgerätenetzwerk (1), um zu überwachen, welches Fertigungsgerät mit welcher Geräteversorgungsleitung verbunden ist und wie viel Energie zu welchem Zeitpunkt an das Fertigungsgerät übertragen wurde, wobei das Netzwerk umfasst:
eine Stromversorgungsleitung (3) mit einer Vielzahl von Versorgungsverbindern (5a, 5b, 5c),
eine Vielzahl von Fertigungsgeräten (7a, 7b, 7c), die jeweils mit einer Geräteversorgungsleitung (9a, 9b, 9c) versehen sind, wobei jede Geräteversorgungsleitung (9a, 9b, 9c) einen Geräteverbinder (11a, 11b, 11c) an dem von dem Fertigungsgerät (7a, 7b, 7c) entfernten Ende der Geräteversorgungsleitung (9a, 9b, 9c) zum Verbinden des Fertigungsgerätes (7a, 7b, 7c) mit einem der Versorgungsverbinder (5a, 5b, 5c) aufweist,
wobei die Versorgungsverbinder (5a, 5b, 5c) und die Geräteverbinder (11a, 11b, 11c) dazu eingerichtet sind, lösbar miteinander gekoppelt zu werden,
**dadurch gekennzeichnet, dass**
die Versorgungsverbinder (5a, 5b, 5c) und/oder die Geräteverbinder (11a, 11b, 11c) jeweils mit einer Überwachungseinheit (13) versehen sind, die Sensormittel (25) und Kommunikationsmittel (27) umfasst,
eine Empfangseinheit (17) zum Empfangen von Daten von den Kommunikationsmitteln (27) vorgesehen ist,
die Geräteverbinder (11a, 11b, 11c) jeweils mit einer Identifizierungseinheit (37) versehen sind, die geeignet ist, ein Identifizierungssignal (39) an die Empfangseinheit (17) zu übertragen, wobei das Identifizierungssignal (39) die Fertigungsgeräte (7a, 7b, 7c) identifiziert,
jedes Sensormittel (25) dazu ausgelegt ist, einen Parameter zu überwachen, der mit der Übertragung von Energie durch den entsprechenden Geräteverbinder (11a, 11b, 11c) zu dem entsprechenden Fertigungsgerät (7a, 7b, 7c) zusammenhängt, und ein Signal (29), das den Parameter darstellt, an das Kommunikationsmittel (27) zu übertragen, und
wobei die Kommunikationsmittel (27) geeignet sind, ein Signal (31), das den Parameter darstellt, an die Empfangseinheit (17) zu übertragen,
wobei Speichermittel (21) an der Empfangseinheit (17) vorgesehen sind, wobei die Speichermittel (21) die Historie des Parameters speichern, der sich auf die Übertragung von Energie durch jeden Geräteverbinder zu dem entsprechenden Fertigungsgerät bezieht, um für Qualitätskontrollfragen analysiert zu werden,
wobei Aktuatormittel (35) vorgesehen sind, die geeignet sind, den Betrieb der Fertigungsgeräte (7a, 7b, 7c) zu stoppen,
wobei die Aktuatormittel (35) an der Überwachungseinheit (13) vorgesehen sind und geeignet sind, die Energiezufuhr zu den Fertigungsgeräten (7a, 7b, 7c) über die Geräteversorgungsleitungen (9a, 9b, 9c) zu stoppen,
wobei Steuermittel (19) in Signalverbindung mit den Sensormitteln (25) und den Aktuatormitteln (35) vorgesehen sind, wobei die Steuermittel (19) angepasst sind, um ein Steuersignal (33) an die Aktuatormittel (35) in Abhängigkeit von einem Sensorsignal (29), das von den Sensormitteln (25) bereitgestellt wird, auszugeben,
wobei die Steuermittel (19) an der Empfangseinheit (17) vorgesehen sind und das Sensorsignal (29) durch den Parameter repräsentiert wird, der sich auf die Übertragung von Energie durch die Geräteverbinder (11a, 11b, 11c) zu den Fertigungsgeräten (7a, 7b, 7c) bezieht, und
wobei die Steuermittel (19) geeignet sind, die Aktuatormittel (35) zu steuern, um Überlastzustände oder Notzustände der Fertigungsgeräte (7a, 7b, 7c) zu antizipieren oder zu verhindern, wobei, wenn der Parameter, der sich auf die Übertragung von Strom durch einen der Geräteverbinder (11a, 11b, 11c) zu dem entsprechenden Fertigungsgerät (7a, 7b, 7c) bezieht, und der durch die Sensormittel (25) überwacht wird, einen vorbestimmten Schwellenwert des Parameters, der einem kritischen Betriebszustand des Fertigungsgeräts (7a, 7b, 7c) entspricht, über- oder unterschreitet, die Aktuatormittel (35) aktiviert werden, um den Betrieb des Fertigungsgerätes (7a, 7b, 7c) zu stoppen, indem die Übertragung von Strom von dem entsprechenden Versorgungsverbinder (5a, 5b, 5c) zu dem Fertigungsgerät (7a, 7b, 7c) gestoppt wird.

2. Netzwerk nach Anspruch 1, wobei die Überwachungseinheit (13) an den Geräteverbindern (11a, 11b, 11c) vorgesehen ist,
wobei die Identifizierungseinheit (37) in der Überwachungseinheit (13) enthalten ist, und wobei das Identifizierungssignal (39) über die Kommunikationsmittel (27) übertragen wird.

3. Netzwerk nach Anspruch 1 oder 2, wobei jeder Versorgungsverbinder (5a, 5b, 5c) mit einem Identifikationssensor (49) versehen ist, der zum Empfang eines Identifizierungssignals (39) eingerichtet ist, das von einem Geräteverbinder (11a, 11b, 11c) übertragen wird, der mit dem Versorgungsverbinder (5a, 5b, 5c) verbunden ist, und
wobei der Identifikationssensor (49) angepasst ist, um ein Netzwerkidentifikationssignal (51) an die Empfangseinheit (17) zu übertragen, wobei das Netzwerkidentifikationssignal (51) die mit dem Versorgungsverbinder (5a, 5b, 5c) verbundenen Fertigungsgeräte (7a, 7b, 7c) identifiziert.

4. Netzwerk nach einem der Ansprüche 1 bis 3, wobei jeder Versorgungsverbinder (5a, 5b, 5c) mit einer Netzwerküberwachungseinheit (15) versehen ist, die ein Netzwerksensormittel (41) und ein Netzwerkkommunikationsmittel (43) umfasst,
wobei die Netzwerksensormittel (41) angepasst sind, um einen Parameter zu überwachen, der mit der Übertragung von Energie durch die Geräteverbinder (11a, 11b, 11c) zu den Fertigungsgeräten (7a, 7b, 7c) zusammenhängt, und um ein Signal (45), das den Parameter darstellt, an die Netzwerkkommunikationsmittel (43) zu übertragen,
wobei die Netzwerkkommunikationsmittel (43) geeignet sind, ein Signal (47), das den Parameter darstellt, an die Empfangseinheit (17) zu übertragen.

5. Netzwerk nach Anspruch 4, wobei die Netzwerküberwachungseinheit (15) mit einer Netzwerkidentifizierungseinheit (53) versehen ist, die angepasst ist, um ein Netzwerkidentifizierungssignal (55), vorzugsweise über die Netzwerkkommunikationsmittel (43), an die Empfangseinheit (17) zu übertragen, wobei das Netzwerkidentifizierungssignal (55) den Versorgungsverbinder (5a) identifiziert.

6. Netzwerk nach einem der Ansprüche 3 und 4, wobei der Identifikationssensor (49) in der Netzwerküberwachungseinheit (15) enthalten ist und
wobei das Netzwerkidentifikationssignal (51) über das Netzwerkkommunikationsmittel (43) übertragen wird.

7. Netzwerk nach Anspruch 1, wobei die Empfangseinheit (17) entfernt von der Überwachungseinheit (13) angeordnet ist.

8. Netzwerk nach Anspruch 7, wobei die Empfangseinheit (17) mit der Überwachungseinheit (13) über eine drahtlose Datenverbindung (23) verbunden ist.

9. Netzwerk nach Anspruch 7, wobei die Empfangseinheit (17) über ein Datenkabel mit der Überwachungseinheit (13) verbunden ist.

10. Netzwerk nach einem der Ansprüche 1 bis 9, wobei die Geräteversorgungsleitungen (9a, 9b, 9c) lösbar mit den Fertigungsgeräten (7a, 7b, 7c) verbunden sind.

11. Verwendung eines Fertigungsgerätenetzwerks (1) zur Qualitätskontrollanalyse, wobei das Netzwerk umfasst:
eine Stromversorgungsleitung (3) mit einer Vielzahl von Versorgungsverbindern (5a, 5b, 5c)
eine Vielzahl von Fertigungsgeräten (7a, 7b, 7c), die jeweils mit einer Geräteversorgungsleitung (9a, 9b, 9c) versehen sind, wobei jede Geräteversorgungsleitung (9a, 9b, 9c) einen Geräteverbinder (11a, 11b, 11c) an dem von dem Fertigungsgerät (7a, 7b, 7c) entfernten Ende der Geräteversorgungsleitung (9a, 9b, 9c) zum Verbinden des Fertigungsgerätes (7a, 7b, 7c) mit einem der Versorgungsverbinder (5a, 5b, 5c) aufweist,
wobei die Versorgungsverbinder (5a, 5b, 5c) und die Geräteverbinder (11a, 11b, 11c) geeignet sind, lösbar miteinander gekoppelt zu werden,
wobei die Versorgungsverbinder (5a, 5b, 5c) und/oder die Geräteverbinder (11a, 11b, 11c) jeweils mit einer Überwachungseinheit (13) versehen sind, die Sensormittel (25) und Kommunikationsmittel (27) umfasst,
wobei eine Empfangseinheit (17) zum Empfangen von Daten von den Kommunikationsmitteln (27) vorgesehen ist,
wobei die Geräteverbinder (11a, 11b, 11c) jeweils mit einer Identifizierungseinheit (37) versehen sind, die geeignet ist, ein Identifizierungssignal (39) an die Empfangseinheit (17) zu übertragen, wobei das Identifizierungssignal (39) die Fertigungsgeräte (7a, 7b, 7c) identifiziert,
wobei jedes Sensormittel (25) angepasst ist, um einen Parameter zu überwachen, der mit der Übertragung von Energie durch den entsprechenden Geräteverbinder (11a, 11b, 11c) zu dem entsprechenden Fertigungsgerät (7a, 7b, 7c) in Beziehung steht, und um ein Signal (29), das den Parameter repräsentiert, an das Kommunikationsmittel (27) zu übertragen, und
wobei das Kommunikationsmittel (27) geeignet ist, ein den Parameter darstellendes Signal (31) an die Empfangseinheit (17) zu übertragen,
wobei Speichermittel (21) an der Empfangseinheit (17) vorgesehen sind, wobei die Speichermittel (21) die Historie des Parameters speichern, der sich auf die Übertragung von Energie durch jeden Geräteverbinder zu dem entsprechenden Fertigungsgerät bezieht, um für Qualitätskontrollfragen analysiert zu werden,
wobei Aktuatormittel (35) vorgesehen sind, die geeignet sind, den Betrieb der Fertigungsgeräte (7a, 7b, 7c) zu stoppen,
wobei die Aktuatormittel (35) an der Überwachungseinheit (13) vorgesehen sind und geeignet sind, die Energiezufuhr zu den Fertigungsgeräten (7a, 7b, 7c) über die Geräteversorgungsleitungen (9a, 9b, 9c) zu stoppen,
wobei Steuermittel (19) in Signalverbindung mit den Sensormitteln (25) und den Aktuatormitteln (35) vorgesehen sind, wobei die Steuermittel (19) angepasst sind, um ein Steuersignal (33) an die Aktuatormittel (35) in Abhängigkeit von einem Sensorsignal (29), das von den Sensormitteln (25) bereitgestellt wird, auszugeben,
wobei die Steuermittel (19) an der Empfangseinheit (17) vorgesehen sind und das Sensorsignal (29) durch den Parameter repräsentiert wird, der sich auf die Übertragung von Energie durch die Geräteverbinder (11a, 11b, 11c) zu den Fertigungsgeräten (7a, 7b, 7c) bezieht, und
wobei die Steuermittel (19) geeignet sind, die Aktuatormittel (35) zu steuern, um Überlastzustände oder Notzustände der Fertigungsgeräte (7a, 7b, 7c) zu antizipieren oder zu verhindern, wobei wenn der Parameter, der sich auf die Übertragung von Strom durch einen der Geräteverbinder (11a, 11b, 11c) zu dem entsprechenden Fertigungsgerät (7a, 7b, 7c) bezieht, und der durch die Sensormittel (25) überwacht wird, einen vorbestimmten Schwellenwert des Parameters, der einem kritischen Betriebszustand des Fertigungsgeräts (7a, 7b, 7c) entspricht, über- oder unterschreitet, die Aktuatormittel (35) aktiviert werden, um den Betrieb des Fertigungsgeräts (7a, 7b, 7c) zu stoppen, indem die Übertragung von Strom von dem entsprechenden Versorgungsverbinder (5a, 5b, 5c) zu dem Fertigungsgerät (7a, 7b, 7c) gestoppt wird.

12. Verfahren zur Qualitätskontrollanalyse in einem Fertigungsgerätenetzwerk (1), wobei das Verfahren umfasst:
- Bereitstellen eines Fertigungsgerätenetzwerks (1), das Folgendes umfasst:
eine Stromversorgungsleitung (3) mit einer Vielzahl von Versorgungsverbindern (5a, 5b, 5c)
eine Vielzahl von Fertigungsgeräten (7a, 7b, 7c), die jeweils mit einer Geräteversorgungsleitung (9a, 9b, 9c) versehen sind, wobei jede Geräteversorgungsleitung (9a, 9b, 9c) einen Geräteverbinder (11a, 11b, 11c) an dem von dem Fertigungsgerät (7a, 7b, 7c) entfernten Ende der Geräteversorgungsleitung (9a, 9b, 9c) zum Verbinden des Fertigungsgerätes (7a, 7b, 7c) mit einem der Versorgungsverbinder (5a, 5b, 5c) aufweist,
wobei die Versorgungsverbinder (5a, 5b, 5c) und die Geräteverbinder (11a, 11b, 11c) geeignet sind, lösbar miteinander gekoppelt zu werden,
wobei die Versorgungsverbinder (5a, 5b, 5c) und/oder die Geräteverbinder (11a, 11b, 11c) jeweils mit einer Überwachungseinheit (13) versehen sind, die Sensormittel (25) und Kommunikationsmittel (27) umfasst,
wobei eine Empfangseinheit (17) zum Empfangen von Daten von den Kommunikationsmitteln (27) vorgesehen ist,
wobei die Geräteverbinder (11a, 11b, 11c) jeweils mit einer Identifizierungseinheit (37) versehen sind, die geeignet ist, ein Identifizierungssignal (39) an die Empfangseinheit (17) zu übertragen, wobei das Identifizierungssignal (39) die Fertigungsgeräte (7a, 7b, 7c) identifiziert,
wobei jedes Sensormittel (25) angepasst ist, um einen Parameter zu überwachen, der mit der Übertragung von Energie durch den entsprechenden Geräteverbinder (11a, 11b, 11c) zu dem entsprechenden Fertigungsgerät (7a, 7b, 7c) in Beziehung steht, und um ein Signal (29), das den Parameter repräsentiert, an die Kommunikationsmittel (27) zu übertragen,
wobei die Kommunikationsmittel (27) geeignet sind, ein den Parameter darstellendes Signal (31) an die Empfangseinheit (17) zu übertragen, und
wobei Speichermittel (21) an der Empfangseinheit (17) vorgesehen sind, wobei die Speichermittel (21) die Historie des Parameters speichern, der sich auf die Übertragung von Energie durch jeden Geräteverbinder zu dem entsprechenden Fertigungsgerät bezieht, wobei Aktuatormittel (35) vorgesehen sind, die geeignet sind, den Betrieb der Fertigungsgeräte (7a, 7b, 7c) zu stoppen,
wobei die Aktuatormittel (35) an der Überwachungseinheit (13) vorgesehen sind und geeignet sind, die Stromzufuhr zu den Fertigungsgeräten (7a, 7b, 7c) durch die Geräteversorgungsleitungen (9a, 9b, 9c) zu stoppen,
wobei Steuermittel (19) in Signalverbindung mit den Sensormitteln (25) und den Aktuatormitteln (35) vorgesehen sind, wobei die Steuermittel (19) angepasst sind, um ein Steuersignal (33) an die Aktuatormittel (35) in Abhängigkeit von einem Sensorsignal (29), das von den Sensormitteln (25) bereitgestellt wird, auszugeben,
wobei die Steuermittel (19) an der Empfangseinheit (17) vorgesehen sind und das Sensorsignal (29) durch den Parameter repräsentiert wird, der sich auf die Übertragung von Energie durch die Geräteverbinder (11a, 11b, 11c) zu den Fertigungsgeräten (7a, 7b, 7c) bezieht, und
wobei die Steuermittel (19) eingerichtet sind, die Aktuatormittel (35) zu steuern, um Überlastzustände oder Notzustände der Fertigungsgeräte (7a, 7b, 7c) zu antizipieren oder zu verhindern, wobei, wenn der Parameter, der sich auf die Übertragung von Energie durch einen der Geräteverbinder (11a, 11b, 11c) zu dem entsprechenden Fertigungsgerät (7a, 7b, 7c) bezieht, und der von den Sensormitteln (25) überwacht wird, einen vorbestimmten Schwellenwert des Parameters, der einem kritischen Betriebszustand der Fertigungsgerät (7a, 7b, 7c) entspricht, über- oder unterschreitet, die Aktuatormittel (35) aktiviert werden, um den Betrieb des Fertigungsgeräts (7a, 7b, 7c) zu stoppen, indem die Übertragung von Energie von dem entsprechenden Versorgungsverbinder (5a, 5b, 5c) zu dem Fertigungsgerät (7a, 7b, 7c) gestoppt wird, und
- Analysieren der gespeicherten Historie des Parameters, der sich auf die Energieübertragung bezieht, für Fragen der Qualitätskontrolle.

## Revendications

1. Un réseau de dispositifs de fabrication pour le contrôle de la qualité (1) pour surveiller, pour des raisons de contrôle de la qualité, quel dispositif de fabrication est connecté à quelle ligne d'alimentation de dispositif et quelle quantité de puissance a été transmise au dispositif de fabrication à quel moment, le réseau comprenant:
une ligne d'alimentation électrique (3) comportant une pluralité de connecteurs d'alimentation (5a, 5b, 5c),
une pluralité de dispositifs de fabrication (7a, 7b, 7c), chacun étant pourvu d'une ligne d'alimentation de dispositif (9a, 9b, 9c), chaque ligne d'alimentation de dispositif (9a, 9b, 9c) ayant un connecteur de dispositif (11a, 11b, 11c) à l'extrémité de la ligne d'alimentation de dispositif (9a, 9b, 9c) éloignée du dispositif de fabrication (7a, 7b, 7c) pour connecter le dispositif de fabrication (7a, 7b, 7c) à l'un desdits connecteurs d'alimentation (5a, 5b, 5c),
lesdits connecteurs d'alimentation (5a, 5b, 5c) et lesdits connecteurs de dispositif (11a, 11b, 11c) étant adaptés pour être couplés de manière amovible les uns aux autres,
**caractérisé en ce que**
les connecteurs d'alimentation (5a, 5b, 5c) et/ou lesdits connecteurs de dispositif (11a, 11b, 11c) sont chacun munis d'une unité de surveillance (13) comprenant des moyens de détection (25) et des moyens de communication (27),
une unité de réception (17) est prévue pour recevoir les données provenant des moyens de communication (27),
les connecteurs de dispositifs (11a, 11b, 11c) sont chacun munis d'une unité d'identification (37) adaptée pour transmettre un signal d'identification (39) à l'unité de réception (17), ledit signal d'identification (39) identifiant les dispositifs de fabrication (7a, 7b, 7c),
chaque moyen de détection (25) étant adapté pour surveiller un paramètre lié au transfert d'énergie par le connecteur de dispositif correspondant (11a, 11b, 11c) vers le dispositif de fabrication correspondant (7a, 7b, 7c) et pour transmettre un signal (29) représentant ledit paramètre au moyen de communication (27), et
ledit moyen de communication (27) étant adapté pour transmettre un signal (31) représentant ledit paramètre à l'unité de réception (17),
dans lequel des moyens de mémoire (21) sont prévus sur ladite unité de réception (17), lesdits moyens de mémoire (21) stockant l'historique du paramètre lié au transfert de puissance à travers chaque connecteur de dispositif vers le dispositif de fabrication correspondant afin d'être analysés pour des questions de contrôle de qualité,
dans lequel des moyens d'actionnement (35) adaptés pour arrêter le fonctionnement des dispositifs de fabrication (7a, 7b, 7c) sont prévus,
dans lequel lesdits moyens d'actionnement (35) sont prévus sur ladite unité de surveillance (13) et sont adaptés pour arrêter l'alimentation en énergie des dispositifs de fabrication (7a, 7b, 7c) par l'intermédiaire desdites lignes d'alimentation des dispositifs (9a, 9b, 9c),
dans lequel des moyens de commande (19) sont prévus en connexion de signal avec lesdits moyens de détection (25) et lesdits moyens d'actionnement (35), lesdits moyens de commande (19) étant adaptés pour envoyer un signal de commande (33) aux moyens d'actionnement (35) en fonction d'un signal de capteur (29) fourni par les moyens de détection (25),
dans lequel lesdits moyens de commande (19) sont prévus sur ladite unité de réception (17), et ledit signal de capteur (29) est représenté par ledit paramètre lié au transfert de puissance par l'intermédiaire desdits connecteurs de dispositif (11a, 11b, 11c) vers les dispositifs de fabrication (7a, 7b, 7c), et
dans lequel les moyens de commande (19) sont adaptés pour commander les moyens d'actionnement (35) de manière à anticiper ou à prévenir les conditions de surcharge ou les conditions d'urgence des dispositifs de fabrication (7a, 7b, 7c), dans lequel, lorsque le paramètre relatif au transfert de puissance par l'un des connecteurs de dispositif (11a, 11b, 11c) au dispositif de fabrication correspondant (7a, 7b), 7c) surveillé par les moyens de détection (25) dépasse ou sous-dépasse une valeur de seuil prédéterminée dudit paramètre correspondant à une condition de fonctionnement critique du dispositif de fabrication (7a, 7b, 7c), les moyens d'actionnement (35) sont activés afin d'arrêter le fonctionnement du dispositif de fabrication (7a, 7b, 7c) en arrêtant le transfert de puissance du connecteur d'alimentation correspondant (5a, 5b, 5c) vers le dispositif de fabrication (7a, 7b, 7c).

2. Réseau selon la revendication 1, dans lequel l'unité de surveillance (13) est prévue sur les connecteurs de dispositif (11a, 11b, 11c),
où l'unité d'identification (37) est incluse dans l'unité de surveillance (13), et
où le signal d'identification (39) est transmis par le moyen de communication (27).

3. Réseau selon la revendication 1 ou 2, dans lequel chaque connecteur d'alimentation (5a, 5b, 5c) est muni d'un capteur d'identification (49) adapté pour recevoir un signal d'identification (39) transmis à partir d'un connecteur de dispositif (11a, 11b, 11c) connecté audit connecteur d'alimentation (5a, 5b, 5c) et
dans lequel ledit capteur d'identification (49) est adapté pour transmettre un signal d'identification de réseau (51) à ladite unité de réception (17), ledit signal d'identification de réseau (51) identifiant les dispositifs de fabrication (7a, 7b, 7c) connectés audit connecteur d'alimentation (5a, 5b, 5c).

4. Réseau selon l'une des revendications 1 à 3, dans lequel chaque connecteur d'alimentation (5a, 5b, 5c) est muni d'une unité de surveillance de réseau (15) comprenant des moyens de détection de réseau (41) et des moyens de communication de réseau (43),
ledit moyen de détection de réseau (41) étant adapté pour surveiller un paramètre lié au transfert de puissance par l'intermédiaire desdits connecteurs de dispositif (11a, 11b, 11c) vers les dispositifs de fabrication (7a, 7b, 7c) et pour transmettre un signal (45) représentant ledit paramètre au moyen de communication de réseau (43),
ledit moyen de communication en réseau (43) étant adapté pour transmettre un signal (47) représentant ledit paramètre à l'unité de réception (17).

5. Réseau selon la revendication 4, dans lequel l'unité de surveillance de réseau (15) est munie d'une unité d'identification de réseau (53) qui est adaptée pour transmettre un signal d'identification de réseau (55), de préférence via les moyens de communication de réseau (43), à l'unité de réception (17), ledit signal d'identification de réseau (55) identifiant le connecteur d'alimentation (5a).

6. Réseau selon les revendications 3 et 4, dans lequel ledit capteur d'identification (49) est inclus dans l'unité de surveillance du réseau (15) et
dans lequel ledit signal d'identification de réseau (51) est transmis via ledit moyen de communication de réseau (43).

7. Réseau selon la revendication 1, dans lequel ladite unité de réception (17) est disposée à distance de ladite unité de surveillance (13).

8. Réseau selon la revendication 7, dans lequel ladite unité de réception (17) est connectée à ladite unité de surveillance (13) via une connexion de données sans fil (23).

9. Réseau selon la revendication 7, dans lequel ladite unité de réception (17) est connectée à ladite unité de surveillance (13) par l'intermédiaire d'un câble de données.

10. Réseau selon l'une des revendications 1 à 9, dans lequel lesdites lignes d'alimentation de dispositifs (9a, 9b, 9c) sont connectées de manière détachable auxdits dispositifs de fabrication (7a, 7b, 7c).

11. Utilisation d'un réseau de dispositifs de fabrication (1) pour l'analyse du contrôle de la qualité, le réseau comprenant :
une ligne d'alimentation électrique (3) comportant une pluralité de connecteurs d'alimentation (5a, 5b, 5c),
une pluralité de dispositifs de fabrication (7a, 7b, 7c), chacun étant pourvu d'une ligne d'alimentation de dispositif (9a, 9b, 9c), chaque ligne d'alimentation de dispositif (9a, 9b, 9c) ayant un connecteur de dispositif (11a, 11b, 11c) à l'extrémité de la ligne d'alimentation de dispositif (9a, 9b, 9c) éloignée du dispositif de fabrication (7a, 7b, 7c) pour connecter le dispositif de fabrication (7a, 7b, 7c) à l'un desdits connecteurs d'alimentation (5a, 5b, 5c),
lesdits connecteurs d'alimentation (5a, 5b, 5c) et lesdits connecteurs de dispositif (11a, 11b, 11c) étant adaptés pour être couplés de manière amovible les uns aux autres,
dans lequel les connecteurs d'alimentation (5a, 5b, 5c) et/ou lesdits connecteurs de dispositif (11a, 11b, 11c) sont chacun munis d'une unité de surveillance (13) comprenant des moyens de détection (25) et des moyens de communication (27),
dans lequel une unité de réception (17) est prévue pour recevoir les données des moyens de communication (27),
dans lequel les connecteurs de dispositifs (11a, 11b, 11c) sont chacun munis d'une unité d'identification (37) adaptée pour transmettre un signal d'identification (39) à l'unité de réception (17), ledit signal d'identification (39) identifiant les dispositifs de fabrication (7a, 7b, 7c),
dans lequel chaque moyen de détection (25) est adapté pour surveiller un paramètre lié au transfert de puissance par le connecteur de dispositif correspondant (11a, 11b, 11c) au dispositif de fabrication correspondant (7a, 7b, 7c) et pour transmettre un signal (29) représentant ledit paramètre au moyen de communication (27), et
dans lequel ledit moyen de communication (27) est adapté pour transmettre un signal (31) représentant ledit paramètre à l'unité de réception (17),
dans lequel des moyens de mémoire (21) sont prévus sur ladite unité de réception (17), lesdits moyens de mémoire (21) stockant l'historique du paramètre lié au transfert de puissance à travers chaque connecteur de dispositif vers le dispositif de fabrication correspondant afin d'être analysés pour des questions de contrôle de qualité,
dans lequel des moyens d'actionnement (35) adaptés pour arrêter le fonctionnement des dispositifs de fabrication (7a, 7b, 7c) sont prévus,
dans lequel lesdits moyens d'actionnement (35) sont prévus sur ladite unité de surveillance (13) et sont adaptés pour arrêter l'alimentation en énergie des dispositifs de fabrication (7a, 7b, 7c) par l'intermédiaire desdites lignes d'alimentation des dispositifs (9a, 9b, 9c),
dans lequel des moyens de commande (19) sont prévus en connexion de signal avec lesdits moyens de détection (25) et lesdits moyens d'actionnement (35), lesdits moyens de commande (19) étant adaptés pour envoyer un signal de commande (33) aux moyens d'actionnement (35) en fonction d'un signal de capteur (29) fourni par les moyens de détection (25),
dans lequel lesdits moyens de commande (19) sont prévus sur ladite unité de réception (17), et ledit signal de capteur (29) est représenté par ledit paramètre lié au transfert de puissance par l'intermédiaire desdits connecteurs de dispositif (11a, 11b, 11c) vers les dispositifs de fabrication (7a, 7b, 7c), et
dans lequel les moyens de commande (19) sont adaptés pour commander les moyens d'actionnement (35) de manière à anticiper ou à prévenir les conditions de surcharge ou les conditions d'urgence des dispositifs de fabrication (7a, 7b, 7c), dans lequel, lorsque le paramètre relatif au transfert de puissance par l'un des connecteurs de dispositif (11a, 11b, 11c) au dispositif de fabrication correspondant (7a, 7b), 7c) surveillé par les moyens de détection (25) dépasse ou sous-dépasse une valeur de seuil prédéterminée dudit paramètre correspondant à une condition de fonctionnement critique du dispositif de fabrication (7a, 7b, 7c), les moyens d'actionnement (35) sont activés afin d'arrêter le fonctionnement du dispositif de fabrication (7a, 7b, 7c) en arrêtant le transfert de puissance du connecteur d'alimentation correspondant (5a, 5b, 5c) vers le dispositif de fabrication (7a, 7b, 7c).

12. Une méthode d'analyse de contrôle de la qualité dans un réseau de dispositifs de fabrication (1), la méthode comprenant:
- Fournir un réseau de dispositifs de fabrication, (1) comprenant une ligne d'alimentation électrique (3) comportant une pluralité de connecteurs d'alimentation (5a, 5b, 5c),
une pluralité de dispositifs de fabrication (7a, 7b, 7c), chacun étant pourvu d'une ligne d'alimentation de dispositif (9a, 9b, 9c), chaque ligne d'alimentation de dispositif (9a, 9b, 9c) ayant un connecteur de dispositif (11a, 11b, 11c) à l'extrémité de la ligne d'alimentation de dispositif (9a, 9b, 9c) éloignée du dispositif de fabrication (7a, 7b, 7c) pour connecter le dispositif de fabrication (7a, 7b, 7c) à l'un desdits connecteurs d'alimentation (5a, 5b, 5c),
lesdits connecteurs d'alimentation (5a, 5b, 5c) et lesdits connecteurs de dispositif (11a, 11b, 11c) étant adaptés pour être couplés de manière amovible les uns aux autres,
dans lequel les connecteurs d'alimentation (5a, 5b, 5c) et/ou lesdits connecteurs de dispositif (11a, 11b, 11c) sont chacun munis d'une unité de surveillance (13) comprenant des moyens de détection (25) et des moyens de communication (27),
dans lequel une unité de réception (17) est prévue pour recevoir les données des moyens de communication (27),
dans lequel les connecteurs de dispositifs (11a, 11b, 11c) sont chacun munis d'une unité d'identification (37) adaptée pour transmettre un signal d'identification (39) à l'unité de réception (17), ledit signal d'identification (39) identifiant les dispositifs de fabrication (7a, 7b, 7c),
dans lequel chaque moyen de détection (25) est adapté pour surveiller un paramètre lié au transfert de puissance par le connecteur de dispositif correspondant (11a, 11b, 11c) vers le dispositif de fabrication correspondant (7a, 7b, 7c) et pour transmettre un signal (29) représentant ledit paramètre au moyen de communication (27),
dans lequel lesdits moyens de communication (27) sont adaptés pour transmettre un signal (31) représentant ledit paramètre à l'unité de réception (17), et
dans lequel des moyens de mémoire (21) sont prévus sur ladite unité de réception (17), lesdits moyens de mémoire (21) stockant l'historique du paramètre lié au transfert de puissance à travers chaque connecteur de dispositif vers le dispositif de fabrication correspondant,
dans lequel des moyens d'actionnement (35) adaptés pour arrêter le fonctionnement des dispositifs de fabrication (7a, 7b, 7c) sont prévus,
dans lequel lesdits moyens d'actionnement (35) sont prévus sur ladite unité de surveillance (13) et sont adaptés pour arrêter l'alimentation en énergie des dispositifs de fabrication (7a, 7b, 7c) par l'intermédiaire desdites lignes d'alimentation des dispositifs (9a, 9b, 9c),
dans lequel des moyens de commande (19) sont prévus en connexion de signal avec lesdits moyens de détection (25) et lesdits moyens d'actionnement (35), lesdits moyens de commande (19) étant adaptés pour envoyer un signal de commande (33) aux moyens d'actionnement (35) en fonction d'un signal de capteur (29) fourni par les moyens de détection (25),
dans lequel lesdits moyens de commande (19) sont prévus sur ladite unité de réception (17), et ledit signal de capteur (29) est représenté par ledit paramètre lié au transfert de puissance par l'intermédiaire desdits connecteurs de dispositif (11a, 11b, 11c) vers les dispositifs de fabrication (7a, 7b, 7c), et
dans lequel les moyens de commande (19) sont adaptés pour commander les moyens d'actionnement (35) de manière à anticiper ou à prévenir les conditions de surcharge ou les conditions d'urgence des dispositifs de fabrication (7a, 7b, 7c), dans lequel, lorsque le paramètre relatif au transfert de puissance par l'un des connecteurs de dispositif (11a, 11b, 11c) au dispositif de fabrication correspondant (7a, 7b), 7c) surveillé par le moyen de détection (25) dépasse ou sous-dépasse une valeur de seuil prédéterminée dudit paramètre correspondant à une condition de fonctionnement critique du dispositif de fabrication (7a, 7b, 7c), le moyen d'actionnement (35) est activé afin d'arrêter le fonctionnement du dispositif de fabrication (7a, 7b, 7c) en arrêtant le transfert de puissance du connecteur d'alimentation correspondant (5a, 5b, 5c) au dispositif de fabrication (7a, 7b, 7c), et
- Analyser l'historique stocké du paramètre lié au transfert d'énergie pour les questions de contrôle de la qualité.
